(19) Europäisches Patentamt
European Patent Office
Office européen des brevets

(11) EP 0 635 916 B1

(12) **FASCICULE DE BREVET EUROPEEN**

(45) Date de publication et mention
de la délivrance du brevet:
**13.11.1996 Bulletin 1996/46**

(51) Int Cl.⁶: **H01S 3/00**, G01R 31/26,
H01S 3/025

(21) Numéro de dépôt: **94401655.9**

(22) Date de dépôt: **19.07.1994**

(54) **Procédé de détermination de la longueur d'onde d'émission de lasers à semi-conducteur à cavité de Fabry-Pérot à partir de mesures électriques**

Verfahren zur Bestimmung der Wellenlänge eines Fabry-Perot-Halbleiterlasers mit Hilfe elektrischer Messungen

Method to determine the wavelength of a fabry-perot semiconductor laser using electrical measurements

(84) Etats contractants désignés:
**DE GB**

(30) Priorité: **21.07.1993 FR 9308956**

(43) Date de publication de la demande:
**25.01.1995 Bulletin 1995/04**

(73) Titulaire: **FRANCE TELECOM**
**75015 Paris (FR)**

(72) Inventeur: **Joindot, Irène**
**F-22300 Lannion (FR)**

(74) Mandataire: **Dubois-Chabert, Guy et al**
**Société de Protection des Inventions**
**25, rue de Ponthieu**
**75008 Paris (FR)**

(56) Documents cités:
**DE-A- 3 802 841**    **US-A- 4 489 477**

- **PATENT ABSTRACTS OF JAPAN vol. 11, no. 143 (E-504) 9 Mai 1987 & JP-A-61 281 570 (HITACHI LTD)**
- **PATENT ABSTRACTS OF JAPAN vol. 9, no. 140 (E-321) 14 Juin 1985 & JP-A-60 022 391 (NIPPON DENKI KK)**
- **PATENT ABSTRACTS OF JAPAN vol. 16, no. 146 (E-1188) 10 Avril 1992 & JP-A-04 003 988 (NEC CORP)**

## Description

La présente invention concerne un procédé de détermination de la longueur d'onde d'émission de lasers à semi-conducteur à cavité de Fabry-Pérot.

Elle s'applique notamment au domaine des télécommunications optiques et tout particulièrement au tri des lasers à semi-conducteur en barrettes, en fonction de leur longueur d'onde d'émission, avant de monter chaque laser sur son embase.

Les lasers ainsi sélectionnés peuvent ensuite être utilisés pour le raccordement d'abonnés à des réseaux multiservices de fibres optiques.

Jusqu'à présent, on a déterminé la longueur d'onde d'émission de chaque laser formé sur une plaque semi-conductrice par des mesures optiques qui sont délicates à effectuer et nécessitent le montage des lasers sur leurs embases.

Or, un grand nombre de tests, surtout des tests optiques, avant soudure et encapsulation, ne permet pas de fabriquer des lasers à semi-conducteur à coût réduit.

La présente invention a pour but de remédier à ces inconvénients et de simplifier les méthodes de test et de sélection des lasers à semi-conducteur à cavité de Fabry-Pérot.

Pour ce faire, la présente invention utilise essentiellement des mesures électriques, et non pas un grand nombre de mesures optiques, afin de déterminer la longueur d'onde de chacun des lasers qui ont été formés sur une même plaque semi-conductrice.

De façon précise, la présente invention a pour objet un procédé de détermination de la longueur d'onde d'émission de lasers à semi-conducteur à cavité de Fabry-Pérot formés sur une même plaque semi-conductrice, ce procédé étant caractérisé en ce qu'on détermine la longueur d'onde d'émission $\lambda 1$ de l'un des lasers de la plaque par des mesures optiques, en ce qu'on découpe la plaque en barrettes, chaque barrette étant constituée d'un ensemble de lasers, et en ce qu'on détermine la longueur d'onde d'émission $\lambda$ de chaque laser de chaque barrette par des mesures électriques relatives au courant électrique I injecté dans ce laser et à la tension électrique V entre les bornes de celui-ci, et en utilisant la formule :

$$\lambda = \Delta + 1,24x(V - RxI)^{-1}$$

dans laquelle R représente la résistance dynamique de ce laser pour un courant I supérieur au courant de seuil de ce laser, $\Delta$ étant un paramètre qui prend sensiblement la même valeur pour tous les lasers de la plaque et que l'on détermine à l'aide de cette formule, en appliquant celle-ci au laser dont la longueur d'onde d'émission vaut $\lambda 1$.

On sait que la résistance dynamique R d'un laser à semi-conducteur à cavité de Fabry-Pérot se calcule à partir de mesures du courant I injecté dans ce laser et de la tension V entre les bornes de ce dernier.

On est capable de déterminer les variations de V en fonction de I et donc la résistance dynamique R qui est égale à dV/dI.

Lorsque I atteint le courant de seuil Io du laser (à partir duquel se produit l'émission laser), on sait que la résistance dynamique R diminue brutalement.

Cette diminution brutale permet de déterminer Io.

Au dessus du seuil (I>Io), on sait qu'il existe la relation suivante entre la longueur d'onde d'émission $\lambda$ du laser (exprimée en $\mu m$), la tension V (exprimée en V), le courant I (exprimé en A) et la résistance dynamique R (exprimée en $\Omega$) :

$$\lambda = \Delta + 1,24x(V - RxI)^{-1}.$$

C'est cette relation (ou une relation dérivée de celle-ci) qui est utilisée dans la présente invention.

En effet, on a constaté que le paramètre $\Delta$ (exprimé en $\mu m$ dans la relation ci-dessus) prend sensiblement la même valeur pour tous les lasers formés sur une même plaque semi-conductrice.

Ainsi $\Delta$ est sensiblement une constante qui dépend de la technologie de fabrication des lasers.

Ce paramètre $\Delta$ est constant à 15% pour un ensemble de lasers provenant d'une même plaque.

Par exemple, $\Delta$ est de l'ordre de 27 nm pour des lasers à croissant enterré émettant à la longueur d'onde de 1,3 $\mu m$, et de l'ordre de 37 nm pour des lasers à ruban enterré émettant à la longueur d'onde de 1,5 $\mu m$.

L'incertitude sur la détermination de la longueur d'onde, qui est finalement de 4 à 5 nm, est tout à fait compatible avec la plage de tolérance sur la longueur d'onde des lasers à prix réduit, plage de tolérance qui est assez grande (55 nm).

Ainsi, conformément à la présente invention, on détermine la longueur d'onde d'émission d'un seul des lasers de la plaque semi-conductrice (ou de toutes les plaques semi-conductrices sur lesquelles ont été formés des lasers par une même technologie).

La ou les plaques sont alors découpées en barrettes.

Ensuite, la longueur d'onde d'émission (à 4 nm près) de chaque laser de chaque barrette se déduit des mesures électriques.

La présente invention sera mieux comprise à la lecture de la description d'un exemple de réalisation donné ci-après, à titre purement indicatif et nullement limitatif.

Etant donné des lasers qui sont formés sur une même plaque semi-conductrice, on veut déterminer la longueur d'onde d'émission $\lambda$ de chacun des lasers de cette plaque.

Pour ce faire, on découpe l'un des lasers de la plaque.

On établit son spectre optique par des mesures optiques classiques et, au moyen de ce spectre, on détermine la longueur d'onde d'émission $\lambda 1$ de ce laser (lon-

gueur d'onde correspondant à la puissance lumineuse maximale), le courant I1 injecté dans ce laser étant supérieur au courant de seuil Io1 de celui-ci.

On note V1 la tension entre les bornes de ce laser qui correspond à ce courant I1.

On détermine également, de façon classique, la résistance dynamique R1 de ce laser au-delà du seuil Io1.

Au moyen de la formule donnée plus haut, on peut alors calculer le paramètre $\Delta$ relatif aux lasers de la plaque semi-conductrice considérée :

$$\Delta = \lambda 1 - 1{,}24 \mathrm{x}(V1 - R1\mathrm{x}I1)^{-1}.$$

Ensuite, on découpe, de façon connue, la plaque en barrettes qui constituent des ensembles de lasers (ce découpage permettant de former les cavités de Fabry-Pérot de ces lasers).

On fait ensuite des mesures électriques pour chacun des lasers de chacune des barrettes.

Ces mesures visent à déterminer la résistance dynamique R de chaque laser pour un courant I injecté dans ce laser supérieur au courant de seuil Io de ce laser, la tension entre les bornes du laser, qui correspond à I, étant notée V.

On est alors capable de connaître la longueur d'onde d'émission $\lambda$ de ce laser, grâce à la formule donnée plus haut et sans aucune mesure optique :

$$\lambda = \Delta + 1{,}24\mathrm{x}(V - R\mathrm{x}I)^{-1}$$

où $\Delta$ est le paramètre que l'on vient de calculer.

Par exemple, on a réalisé des lasers à croissant enterré sur une plaque en InP par la technologie d'épitaxie en phase liquide ou LPE (Liquid Phase Epitaxy).

On a découpé l'un de ces lasers et l'on a mesuré optiquement sa longueur d'onde d'émission $\lambda 1$ que l'on a trouvée égale à 1,292 µm.

Des mesures électriques ont donné V1=1,06V, I1=0,0157 A et R1=5,1 $\Omega$ (avec les notations utilisées plus haut) d'où $\Delta$=27nm pour la plaque.

Après avoir découpé cette plaque en barrettes, on a obtenu, pour l'un des lasers de l'une des barrettes : I=0,0155 A, V=1,048 V, R=4,5 $\Omega$ (avec les notations utilisées plus haut), d'où une longueur d'onde d'émission $\lambda$ égale à 1,295 µm, valeur qui est peu différente de celle qui est obtenue par des mesures optiques, à savoir 1,293 µm.

D'une manière générale, des mesures comparatives montrent que les longueurs d'onde déterminées par le procédé objet de l'invention sont peu différentes de celles qui sont obtenues par des mesures optiques.

## Revendications

1. Procédé de détermination de la longueur d'onde d'émission de lasers à semi-conducteur à cavité de Fabry-Pérot formés sur une même plaque semi-conductrice, ce procédé étant caractérisé en ce qu'on détermine la longueur d'onde d'émission $\lambda 1$ de l'un des lasers de la plaque par des mesures optiques, en ce qu'on découpe la plaque en barrettes, chaque barrette étant constituée d'un ensemble de lasers, et en ce qu'on détermine la longueur d'onde d'émission $\lambda$ de chaque laser de chaque barrette par des mesures électriques relatives au courant I injecté dans ce laser et à la tension V entre les bornes de celui-ci, et en utilisant la formule :

$$\lambda = \Delta + 1{,}24\mathrm{x}(V - R\mathrm{x}I)^{-1}$$

dans laquelle R représente la résistance dynamique de ce laser pour un courant I supérieur au courant de seuil de ce laser, $\Delta$ étant un paramètre qui prend sensiblement la même valeur pour tous les lasers de la plaque et que l'on détermine à l'aide de cette formule, en appliquant celle-ci au laser dont la longueur d'onde d'émission vaut $\lambda 1$.

## Patentansprüche

1. Verfahren zur Bestimmung der Wellenlänge eines Fabry-Pérot-Halbleiterlasers, der aus einer Halbleiterplatine besteht, dadurch gekennzeichnet, daß die Wellenlänge $\lambda 1$ eines der Laser auf der Platine durch optische Messungen bestimmt wird, und daß die Platine in Streifen getrennt wird, wobei jeder Streifen eine Gruppe von Lasern umfaßt, und daß die Wellenlänge $\lambda$ jedes Lasers auf jedem Streifen durch elektrische Messungen im Verhältnis zum Injektionsstrom I im Laser und der zwischen dessen Klemmen anliegenden Spannung V bestimmt wird, wozu die folgende Formel verwendet wird:

$$\lambda = \Delta \div 1{,}24\mathrm{x}(V - R\mathrm{x}I)^{-1}$$

in der R die dynamische Referenz des Lasers für einen Strom I darstellt, der höher ist als der Schwellenstrom des Lasers, und $\Delta$ ein Parameter ist, der für alle Laser der Platine denselben Wert annimmt, und den man mit Hilfe dieser Formel bestimmt, indem man diese auf den Laser anwendet, dessen Wellenlänge $\lambda 1$ ist.

## Claims

1. Method of determining the emission wavelength of Fabry-Pérot cavity semiconductor lasers formed on the same semiconducting plate, this method being characterised in that the emission wavelength $\lambda 1$ of

one of the lasers of the plate is determined by optical measurements, in that the plate is cut into small bars, each small bar being constituted by a set of lasers, and in that the emission wavelength $\lambda$ of each laser of each small bar is determined by electrical measurements relating to the current I injected into this laser and to the voltage V between the terminals thereof, and by using the formula:

$$\lambda = \Delta \div 1.24 \text{ x } (V - R \text{ x } I)^{-1}$$

where R represents the dynamic resistance of this laser for a current I greater than the threshold current of this laser, $\Delta$ being a parameter which takes substantially the same value for all the lasers of the plate and which is determined using this formula by applying it to the laser whose emission wavelength is equal to $\lambda 1$.